# EUROPEAN PATENT APPLICATION

(11) **EP 4 582 198 A1**
(43) Date of publication of application: **09.07.2025**
(21) Application number: 23860067.0
(22) Date of filing: 17.08.2023
(51) Int. Cl.: B23B 27/14, B23C 5/16, C23C 14/06

(54) **COATED TOOL**

(30) Priority: 29.08.2022 JP 2022135969
(71) Applicant: MOLDINO Tool Engineering, Ltd., Tokyo 130-0026 (JP)
(72) Inventor: SASAKI, Tomoya, Narita-shi, Chiba 286-0825 (JP)
(74) Representative: Hoffmann Eitle
(86) International application number: PCT/JP2023/029725
(87) International publication number: WO 2024/048304

(57) **Abstract**

A coated tool includes a hard coating on a substrate. The hard coating is a nitride or a carbonitride containing 70 atom% or more and 90 atom% or less of Al and 10 atom% or more and 30 atom% or less of Cr with respect to a total amount of metal elements including metalloid elements, and containing 0.50 atom% or less of argon (Ar) with respect to a total amount of the metal elements including metalloid elements and non-metal elements. The hard coating has a crystal structure consisting of cubic crystals and hexagonal crystals. In the hard coating, in an X-ray intensity distribution on an α-axis in a positive pole figure of (111) planes of the cubic crystals, in a case where a maximum intensity is denoted by IA and a minimum intensity is denoted by IB in an α angle range of 10° to 90°, IB is IA × 0.5 or more. In an X-ray intensity distribution on an α-axis in a positive pole figure of (110) planes of the hexagonal crystals, in a case where a maximum intensity is denoted by Ia and a minimum intensity is denoted by Ib in the α angle range of 10° to 90°, Ib is Ia × 0.5 or more.

## Description

### TECHNICAL FIELD

The present invention relates to a coated tool applied to a tool such as a mold or a cutting tool.

Priority is claimed on Japanese Patent Application No. 2022-135969, filed August 29, 2022, the content of which is incorporated herein by reference.

### BACKGROUND ART

An AlCr nitride is a film type having excellent wear resistance and heat resistance, and is widely applied to coated molds or coated cutting tools. In recent years, coated tools coated with an Al-rich AlCr nitride having an Al content ratio of more than 70 atom% using an arc ion plating method have started to be proposed (Patent Documents 1 to 3).

### Citation List

### Patent Documents

Patent Document 1: Japanese Unexamined Patent Application, First Publication No. 2016-032861
Patent Document 2: Japanese Unexamined Patent Application, First Publication No. 2018-059146
Patent Document 3: Japanese Unexamined Patent Application, First Publication No. 2020-040175

### SUMMARY OF INVENTION

### Technical Problem

In a small-diameter tool having a tool diameter of 2 mm or less, the influence of droplets on the tool performance is likely to become large. The present inventors have confirmed that an Al-rich AlCr nitride, the coating of which is performed by an arc ion plating method, is likely to have many droplets, and there is room for improvement in the durability of a tool.

The number of droplets can be reduced by using a sputtering method in the formation of a hard coating. However, in a case where a hard coating is simply formed using the sputtering method, wear resistance may be inferior to that of a hard coating formed using the arc ion plating method.

The present invention has been made in view of the above-described circumstances, and an object of the present invention is to provide a coated tool that realizes durability equal to or higher than in the case of using an arc ion plating method while reducing the number of droplets through the application of a sputtering method, for an Al-rich AlCr nitride or carbonitride.

### Solution to problem

A coated tool according to an aspect of the present invention is a coated tool including a substrate and a hard coating on the substrate, in which the hard coating is a nitride or a carbonitride containing 70 atom% or more and 90 atom% or less of Al and 10 atom% or more and 30 atom% or less of Cr with respect to a total amount of metal elements including metalloid elements, and containing 0.50 atom% or less of argon (Ar) with respect to a total amount of the metal elements including metalloid elements and non-metal elements, and has a crystal structure consisting of cubic crystals and hexagonal crystals, in the hard coating, in an X-ray intensity distribution on an α-axis in a positive pole figure of (111) planes of the cubic crystals, in a case where a maximum intensity is denoted by IA and a minimum intensity is denoted by IB in an α angle range of 10° to 90°, IB is IA × 0.5 or more, and in an X-ray intensity distribution on an α-axis in a positive pole figure of (110) planes of the hexagonal crystals, in a case where a maximum intensity is denoted by Ia and a minimum intensity is denoted by Ib in the α angle range of 10° to 90°, Ib is Ia × 0.5 or more.

IB is preferably IA × 0.6 or more.

### Advantageous Effects of Invention

According to the present invention, it is possible to obtain the coated tool provided with a sputtered coating of an Al-rich AlCr nitride and having excellent durability.

### BRIEF DESCRIPTION OF DRAWINGS

[FIG. 1] An example of an X-ray intensity distribution on an α-axis in a positive pole figure of (111) planes of cubic crystals in an AlCr nitride according to Example 1.
[FIG. 2] An example of an X-ray intensity distribution on an α-axis in a positive pole figure of (110) planes of hexagonal crystals in the AlCr nitride according to Example 1.
[FIG. 3] An example of an X-ray intensity distribution on an α-axis in a positive pole figure of (111) planes of cubic crystals in an AlCr nitride according to Comparative Example 1.

### DESCRIPTION OF EMBODIMENTS

The present inventors have confirmed that, in a sputtered coating of an Al-rich AlCr nitride or carbonitride, even in a case of having a cubic crystal structure and a hexagonal crystal structure, when orientations of crystals are controlled, durability of a tool is excellent. Hereinafter, the details of an embodiment of the present invention will be described.

A coated tool of the present embodiment is a coated tool including an Al-rich nitride or carbonitride mainly composed of Al and Cr on a surface of a substrate. The coated tool of the present embodiment can be applied to molds or cutting tools. Particularly, the present invention is applied to small-diameter end mills having a tool diameter of preferably 5 mm or less, still more preferably 3 mm or less.

In the present example, the substrate is not particularly limited. Cold tool steel, hot tool steel, high-speed steel, cemented carbide, or the like may be applied according to the application as appropriate. The substrate may be subjected to a nitriding treatment, a bombardment treatment, or the like in advance.

A hard coating according to the present embodiment is a nitride or a carbonitride, and contains 70 atom% or more and 90 atom% or less of Al and 10 atom% or more and 30 atom% or less of Cr with respect to the total amount of metal (including metalloids and the same applies hereinafter) elements. A nitride or a carbonitride mainly composed of Al and Cr is a film type having an excellent balance between wear resistance and heat resistance, and has excellent adhesion to the substrate. It is preferable that the hard coating according to the present embodiment is a nitride having more excellent heat resistance.

In the hard coating according to the present embodiment, when the total amount of the metal elements is set to 100 atom%, the Al content ratio is set to 70 atom% or more. The heat resistance is improved as the amount of Al contained in the hard coating is increased. In addition, an oxidation protection film is easily formed on the tool surface, and the coating structure is made fine, so that wear of the hard coating due to welding is easily suppressed. Furthermore, the Al content ratio is preferably 75 atom% or more. On the other hand, when the Al content ratio is too large, the toughness of the hard coating is significantly reduced. For this reason, in the hard coating according to the present embodiment, when the total amount of the metal elements is set to 100 atom%, the Al content ratio is set to 90 atom% or less. Furthermore, the Al content ratio is preferably 85 atom% or less.

In the hard coating according to the present embodiment, when the total amount of the metal elements is set to 100 atom%, the Cr content ratio is set to 10 atom% or more. Accordingly, a uniform and dense oxidation protection film is easily formed on the tool surface during processing, and damage to the tool is easily suppressed. Furthermore, the Cr content ratio is preferably set to 15 atom% or more. On the other hand, when the Cr content ratio is too large, the Al content ratio is relatively low, and it is difficult to obtain an effect of increasing the Al content ratio. For this reason, in the hard coating according to the present embodiment, when the total amount of the metal elements is set to 100 atom%, the Cr content ratio is set to 30 atom% or less. Furthermore, the Cr content ratio is preferably 25 atom% or less.

In the hard coating according to the present embodiment, when the total amount of the metal elements is set to 100 atom%, the total Al and Cr content ratio is preferably set to 90 atom% or more. In addition, the hard coating according to the present embodiment may be a nitride or a carbonitride of Al and Cr.

The content ratios of the metal elements of the hard coating according to the present embodiment can be measured for the mirror-finished hard coating using an electron probe micro analyzer (EPMA). In this case, for example, after a surface of the hard coating is mirror-finished, analysis was performed at five points where each analysis range is approximately 1 µm in diameter, and the content ratio can be obtained from an average of the analysis results.

The hard coating according to the present embodiment may contain metal elements other than Al and Cr. For example, for the purpose of improving wear resistance and heat resistance, the hard coating according to the present embodiment can also contain one element or two or more elements selected from elements of Groups 4a, 5a, and 6a of the periodic table and Si, B, Y, Yb, and Cu. These elements are generally contained to improve coating properties of the coated tool, and can be added within a range that does not significantly deteriorate the durability of the coated tool. However, when the content ratios of the metal elements other than Al and Cr are too large, the durability of the coated tool may be deteriorated. For this reason, in a case where the hard coating according to the present embodiment contains metal elements other than Al and Cr, when the total amount of the metal elements is set to 100 atom%, the total content ratio thereof is preferably 10 atom% or less, more preferably 5 atom% or less.

The hard coating according to the present embodiment contains 0.50 atom% or less of argon (Ar) with respect to the total amount of the metal elements and non-metal elements. The hard coating according to the present embodiment is a sputtered coating, and is a sputtered hard coating. The frequency of occurrence of droplets that become defects in the hard coating can be reduced by applying a sputtering method. On the other hand, since a target component is sputtered using argon ions in the sputtering method, the hard coating coated by the sputtering method may contain a considerable amount of argon. Particularly, argon is likely to concentrate at grain boundaries, and when the grain size becomes finer, the argon content ratio tends to increase. However, when the argon content ratio increases, the bonding force between grains at the grain boundaries decreases. As in the hard coating according to the present embodiment, in a hard coating having a high Al content ratio, since argon contained in excess may become defects, it is effective to keep the Ar content ratio to a certain level or less. Specifically, the hard coating according to the present embodiment contains 0.50 atom% or less of argon with respect to the total amount of the metal elements and non-metal elements. Furthermore, the argon content ratio is preferably set to 0.40 atom% or less.

When sputtering is performed using a mixed gas containing a rare gas other than argon, the hard coating according to the present embodiment may also contain the rare gas other than argon.

In the sputtering method, when the argon content ratio contained in the hard coating is brought as close to 0 atom% as possible, the flow rate of argon becomes too small, and sputtering becomes unstable. In addition, even if the argon content ratio is brought close to 0 atom%, basic properties of the hard coating applied to cutting tools, such as toughness, heat resistance, and wear resistance, may be impaired. In the hard coating according to the present embodiment, the lower limit of the argon content ratio is not particularly limited; however, in order to stabilize the sputtering method and ensure the basic properties of the hard coating applied to the coated tool, it is preferable that the argon content ratio is set to 0.02 atom% or more. Furthermore, the argon content ratio is preferably set to 0.05 atom% or more. Furthermore, the argon content ratio is preferably set to 0.10 atom% or more.

Similarly to the above-mentioned measurement of the content ratios of the metal element, the argon content ratio of the hard coating according to the present embodiment can be measured for the mirror-finished hard coat using an electron probe micro analyzer (EPMA). Similarly to the above-mentioned measurement of the content ratios of the metal elements, after mirror-finishing, analysis was performed at five points where each analysis range is approximately 1 µm in diameter, and the argon content ratio can be obtained from an average of the analysis results.

The hard coating according to the present embodiment may contain very small amounts of argon, oxygen, and carbon as non-metal elements in addition to nitrogen.

### <Crystal Structure>

The hard coating according to the present embodiment consists of cubic crystals and hexagonal crystals. In the hard coating according to the present embodiment, in an X-ray intensity distribution on an α-axis in a positive pole figure of (111) planes of the cubic crystals, in a case where a maximum intensity is denoted by IA and a minimum intensity is denoted by IB in an α angle range of 10° to 90°, IB is IA × 0.5 or more. As a result, the difference between the maximum intensity IA and the minimum intensity IB is small, the X-ray intensity distribution of the (111) planes of the cubic crystals is likely to be uniform in the α angle range of 10° to 90°, and the (111) planes of the cubic crystals, which are the densest planes, enter a state of not being strongly oriented in a specific direction. In addition, in the hard coating according to the present embodiment, in an X-ray intensity distribution on an α-axis in a positive pole figure of (110) planes of the hexagonal crystals, in a case where a maximum intensity is denoted by Ia and a minimum intensity is denoted by Ib in an α angle range of 10° to 90°, Ib is Ia × 0.5 or more. As a result, the difference between the maximum intensity Ia and the minimum intensity Ib is small, the X-ray intensity distribution of the (110) planes of the hexagonal crystals is likely to be uniform in the α angle range of 10° to 90°, and the hexagonal crystals enter a state of not being strongly oriented in a specific direction. It is presumed that, since the (111) planes of the cubic crystals and the (110) planes of the hexagonal crystals are not strongly oriented in a specific direction, damage to the coating is easily suppressed and durability is improved.

IB is preferably IA × 0.6 or more. Furthermore, it is preferable that IB is IA × 0.7 or more. In the hard coating according to the present embodiment, the (111) plane of the cubic crystal is preferably a crystal plane that exhibits the maximum intensity in an X-ray diffraction.

### <Interlayer Coating and Upper Layer>

In the coated tool of the present embodiment, in order to further improve adhesion of the hard coating, an intermediate coating may be separately provided between the substrate of the tool and the hard coating, if necessary. For example, a layer made of any of metal, nitride, carbonitride, and carbide may be provided between the substrate of the tool and the hard coating.

In addition, a hard coating having a different component ratio or a different composition from the hard coating according to the present embodiment may be separately formed on the hard coating according to the present embodiment. Furthermore, the hard coating according to the present embodiment and a separate hard coating having a different composition ratio or a different composition from the hard coating according to the present embodiment may be laminated on each other.

### <Droplet>

In the hard coating according to the present embodiment, in a cross-sectional observation, the number of droplets having an equivalent circle diameter of 1 µm or more is preferably 5 or less per 100 µm². In an arc ion plating method, "droplets" in the present specification are deposits on the hard coating caused by molten particles of approximately 1 to several tens of µm flying out from a cathode. In the sputtering method, "droplets" in the present specification are deposits on the hard coating caused by metal particles of approximately 1 to several tens of µm suddenly scattered from a target.

In the hard coating coated by a physical vapor deposition method, droplets may become main physical defects. Particularly, since coarse droplets having an equivalent circle diameter of 1 µm or more may become starting points for breakages inside the hard coating, the toughness of the hard coating can be enhanced by reducing the frequency of occurrence of the droplets. In the present embodiment, in a cross-sectional observation of the hard coating, the number of droplets having an equivalent circle diameter of 1 µm or more is preferably set to 5 or less per 100 µm². More preferably, the number of droplets is 3 or less per 100 µm². Still more preferably, the number of droplets is 1 or less per 100 µm². Furthermore, it is preferable that droplets having an equivalent circle diameter of 5 µm or more are not contained.

In addition, the number of droplets having an equivalent circle diameter of 1 µm or more on the surface of the hard coating is preferably 5 or less per 100 µm². More preferably, the number of droplets on the surface of the hard coating is 3 or less per 100 µm². Still more preferably, the number of droplets on the surface of the hard coating is 1 or less per 100 µm².

In evaluating droplets in a cross-sectional observation of the hard coating, the hard coating is mirror-finished and then processed using a focused ion beam method, and a mirror-finished surface is observed in a plurality of visual fields at a magnification of 5,000 to 10,000 times using a transmission electron microscope.

In addition, the number of droplets on the surface of the hard coating can be obtained by observing the surface of the hard coating using a scanning electron microscope (SEM) or the like.

### <Manufacturing Method>

In coating with the hard coating according to the present embodiment, it is preferable to apply a sputtering method in which three or more AlCr alloy targets are used, electric power is sequentially applied to the targets, and when the target to which electric power is applied is switched, a time for which electric power is simultaneously applied to both the target to which the application of electric power is ended and the target to which the application of electric power is started is provided. In such a sputtering method, a state where the ionization rates of the targets are high is maintained during coating, hard coatings that are dense at micro level are obtained, and there is a tendency that argon or oxygen which are inevitably contained is small in content. Then, it is preferable that the internal furnace temperature of a sputtering apparatus is set to 350°C to 500°C, the negative pressure bias voltage applied to the substrate is set to -200 V to -70 V, and Ar gas and N₂ gas are introduced to set the internal furnace pressure to 0.1 Pa to 0.4 Pa. In the case of coating with a carbonitride, a very small amount of carbon may be added to the target, or some of the reaction gas may be replaced with methane gas.

The maximum electric power density of an electric power pulse is preferably set to 0.1 kW/cm² or more. The maximum electric power density is still more preferably set to 0.3 kW/cm² or more. In addition, in the present composition system, when the energy of film-forming ions is too high, the hexagonal crystals become too abundant. For this reason, the maximum electric power density of an electric power pulse is preferably set to 0.7 kW/cm² or less. The maximum electric power density is still more preferably set to 0.6 kW/cm² or less.

The time of application of the electric power pulse to individual targets is preferably set to 30 milliseconds or less. In addition, the time for which electric power is simultaneously applied to both the alloy target to which the application of electric power is ended and the alloy target to which the application of electric power is started is preferably set to 20 microseconds or more and 100 microseconds or less.

### Example 1

### <Substrate>

As a substrate, a 2-flute ball end mill made of a cemented carbide having a composition of WC (bal.)-Co (8.0% by mass)-VC (0.3% by mass)-Cr₃C₂ (0.5% by mass) and a hardness of 94.0 HRA (Rockwell hardness, a value measured in accordance with JIS G 0202) was prepared.

In Example 1, a sputtering apparatus in which six sputtering evaporation sources can be mounted was used. Among these vapor deposition sources, six Al80Cr20 alloy targets (the numerical values are atomic ratios, the same applies hereinafter) were installed in the apparatus as vapor deposition sources to perform the coating of a hard coating.

A tool that was the substrate was fixed to a sample holder in the sputtering apparatus, and a bias power supply was connected to the tool. The bias power supply has a structure in which a negative bias voltage is applied to the tool independently of the target. The tool rotates at two revolutions per minute, and revolves via a fixing jig and the sample holder. The distance between the tool and the target surface was set to 100 mm.

As introduction gases, Ar and N₂ were used, and the introduction gases were introduced from a gas supply port provided in the sputtering apparatus.

### <Bombardment Treatment>

First, before the tool was coated with a hard coating, a bombardment treatment was performed on the tool in the following procedure. Heating was performed for 30 minutes in a state where the internal furnace temperature was set to 400°C by a heater in the sputtering apparatus. Thereafter, the inside of the furnace of the sputtering apparatus was evacuated to set the internal furnace pressure to 5.0 × 10⁻³ Pa or less. Then, an Ar gas was introduced into the furnace of the sputtering apparatus, and the internal furnace pressure was adjusted to 0.8 Pa.

Then, a DC bias voltage of -170 V was applied to the tool, and cleaning (bombardment treatment) was performed on the tool by Ar ions for 20 minutes or more.

### <Coating of Hard Coating>

In the coating of Example 1, the internal furnace temperature was set to 400°C, and Ar gas (0.2 Pa) and N₂ gas (0.1 Pa) were introduced into the furnace of the sputtering apparatus to set internal furnace pressure to 0.3 Pa. A DC bias voltage was applied to the substrate, the overlapping time of electric power applied to the target was set to 50 microseconds, and the discharge time per cycle of electric power applied to each target was set to 1 millisecond. Then, the negative pressure bias voltage applied to the substrate was set to -120 V, the maximum electric power was set to 0.4 kW/cm², and electric power was continuously applied to the six Al80Cr20 alloy targets to coat a surface of the substrate with a hard coating of approximately 3.0 µm.

In Comparative Example 1, an arc ion plating apparatus was used. An Al60Cr40 alloy target was installed in the apparatus as a vapor deposition source. First, cleaning (bombardment treatment) was performed on the tool by Ar ions. Next, the internal furnace pressure of the arc ion plating apparatus was set to 5.0 × 10⁻³ Pa or less by evacuation, the internal furnace temperature was set to 500°C, and N₂ gas was introduced to set the internal furnace pressure to 3.2 Pa. Next, a DC bias voltage of
- 100 V was applied to the tool, and a current of 150 A was applied to the Al60Cr40 alloy target to coat the surface of the tool with a hard coating of approximately 3.0 µm. Comparative Example 1 is a coated cutting tool having a hard coating with a composition generally used in the market.

A coating composition of the hard coating was measured by wavelength-dispersive electron probe microanalysis (WDS-EPMA) attached to an electron probe micro analyzer (JXA-8500F manufactured by JEOL Ltd.). The ball end mill for the evaluation of physical properties was mirror-finished, the acceleration voltage was set to 10 kV, the irradiation current was set to 5 × 10⁻⁸ A, the acquisition time was set to 10 seconds, measurement was performed at five points where each analysis region is 1 µm in diameter, and metal content ratios and an Ar content ratio in the total of metal components and non-metal components of the hard coating were obtained from the average value of the analysis results.

The crystal structure was confirmed using an X-ray diffractometer (EMPYREA manufactured by PaNalytical Corporation) under measurement conditions where the tube voltage was 45 kV, the tube current was 40 mA, the X-ray source was Cuk α (λ = 0.15405 nm), and 2θ was 20 to 80 degrees.

Measurement conditions for the X-ray intensity distribution using the positive pole figure were as follows. When a normal line of the sample surface was on a plane determined by an incident line and a diffraction line, the α angle was set to 90°.

When the α angle was 90°, the α angle became a central point on the positive pole figure.
Tube bulb: CuK α ray
Output: 45 kV, 200 mA
Beam: Parallel method
Optical system: In-plane
Detector: D/teX Ultra 250
Solar slit opening angle: 0.5 deg.
Incident slit width: 1.0 mm
Light-receiving slit width: 1.0 mm
Scanning method: Concentric circle
β scanning range: 0° to 360°/3.0° step
α scanning range: 0 to 90°/3.0° step

**[Table 1]**

| Sample No | Composition (atom%) | Crystal structure | Ar (atom%) | IA | IB | Ia | Ib |
|---|---|---|---|---|---|---|---|
| Example 1 | (Al80Cr20)N | fcc + hep | 0.36 | 171 | 141 | 107 | 75 |
| Comparative Example 1 | (Al60Cr40)N | fcc | 0 | 233 | 98 | - | - |

As the results of X-ray diffraction, Example 1 had cubic crystals and hexagonal crystals. On the other hand, Comparative Example 1 had cubic crystals and did not include hexagonal crystals.

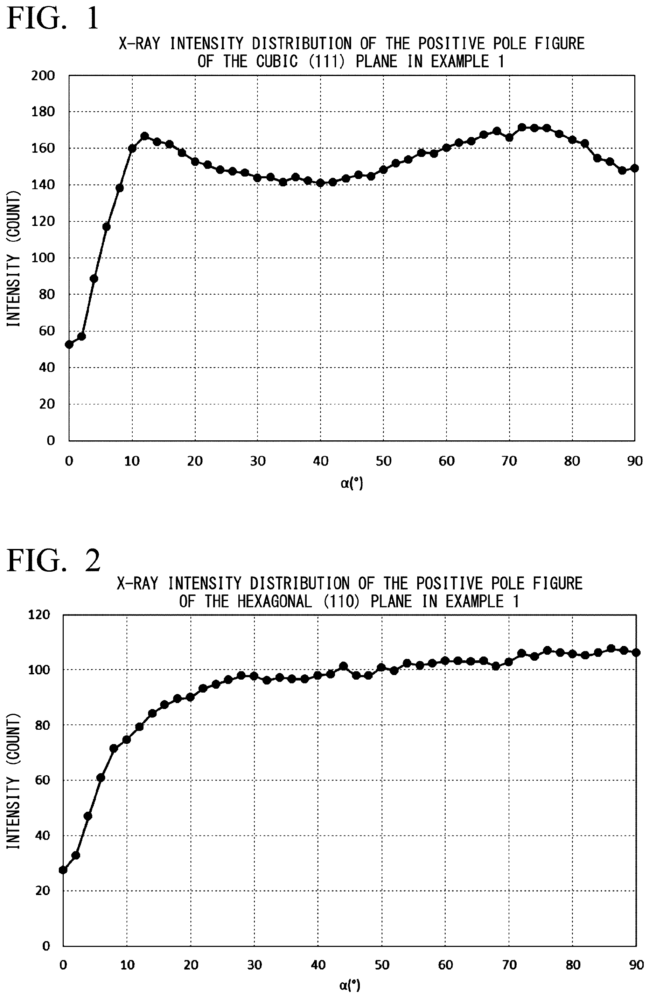

FIG. 1 shows an example of an X-ray intensity distribution on an α-axis in a positive pole figure of (111) planes of cubic crystals in an AlCr nitride according to Example 1.

FIG. 2 shows an example of an X-ray intensity distribution on an α-axis in a positive pole figure of (110) planes of hexagonal crystals in the AlCr nitride according to Example 1.

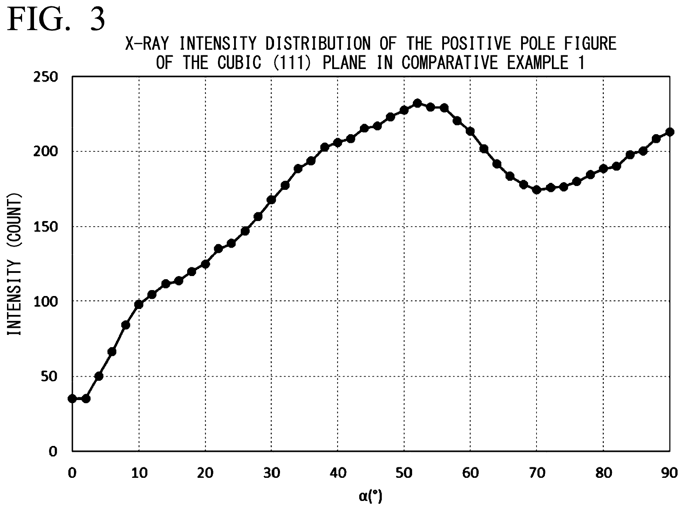

FIG. 3 shows an example of an X-ray intensity distribution on an α-axis in a positive pole figure of (111) planes in an AlCr nitride according to Comparative Example 1.

As shown in FIG. 1, in Example 1, in the X-ray intensity distribution of the (111) planes of the cubic crystals, the difference between a maximum intensity and a minimum intensity is small at an α angle of 10° to 90°. In Example 1, the maximum intensity IA of the (111) planes of the cubic crystals was 171, the minimum intensity IB was 141, IB was 0.82 times IA, and IB was IA × 0.5 or more. In addition, as shown in FIG. 2, in Example 1, the difference between a maximum intensity and a minimum intensity of the X-ray intensity distribution of the (110) planes of the hexagonal crystals is also small at an α angle of 10° to 90°. In Example 1, the maximum intensity Ia of the (110) planes of the hexagonal crystals was 107, the minimum intensity Ib was 75, Ib was 0.70 times Ia, and Ib was Ia × 0.5 or more.

On the other hand, as shown in FIG. 3, in Comparative Example 1, the difference between the maximum intensity and the minimum intensity in the X-ray intensity distribution of the (111) planes of the cubic crystals is larger than that in Example 1. In Comparative Example 1, the maximum intensity IA of the (111) planes of the cubic crystals was 233, the minimum intensity IB was 98, IB was 0.42 times IA, and IB was less than IA × 0.5.

### (Condition) Dry processing

Tool: 2-flute carbide ball end mill
Model number: EPDBE2010-6, ball radius 0.5 mm
Cutting method: Bottom cutting
Work material: STAVAX (52 HRC) (manufactured by Bohler-Uddeholm Co., Ltd.)
Depth of cut: 0.03 mm in an axial direction, 0.03 mm in a radial direction
Cutting speed: 67.8 m/min
One blade feed amount: 0.0135 mm/blade
Cutting distance: 15 m
Evaluation method: After cutting, the work material was observed using a scanning electron microscope at a magnification of 1000 times to measure widths of abrasion between the tool and the work material on a flank face of the tool, and a portion having the largest abrasion width thereamong was defined as a flank face maximum wear width.

**[Table 2]**

| Sample No | Flank face maximum wear width (µm) |
|---|---|
| Example 1 | 10 |
| Comparative Example 1 | 15 |

Example 1 had a small flank face maximum wear width and had more excellent durability than that of Comparative Example 1. It is presumed that the hard coating according to Example 1 contains a large amount of Al, and the (111) planes of the cubic crystals and the (110) planes of the hexagonal crystals are not strongly aligned in a specific direction, whereby damage to the coating is suppressed, and the durability is more excellent than that of Comparative Example 1.

## Claims

1. A coated tool comprising:
a substrate; and
a hard coating on the substrate,
wherein the hard coating is a nitride or a carbonitride containing 70 atom% or more and 90 atom% or less of Al and 10 atom% or more and 30 atom% or less of Cr with respect to a total amount of metal elements including metalloid elements, and containing 0.50 atom% or less of argon (Ar) with respect to a total amount of the metal elements including metalloid elements and non-metal elements, and has a crystal structure consisting of cubic crystals and hexagonal crystals,
in the hard coating, in an X-ray intensity distribution on an α-axis in a positive pole figure of (111) planes of the cubic crystals, in a case where a maximum intensity is denoted by IA and a minimum intensity is denoted by IB in an α angle range of 10° to 90°, IB is IA × 0.5 or more, and
in an X-ray intensity distribution on an α-axis in a positive pole figure of (110) planes of the hexagonal crystals, in a case where a maximum intensity is denoted by Ia and a minimum intensity is denoted by Ib in the α angle range of 10° to 90°, Ib is Ia × 0.5 or more.

2. The coated tool according to Claim 1,
wherein IB is IA × 0.6 or more.
